# EUROPEAN PATENT APPLICATION

(11) **EP 1 475 846 A2**
(43) Date of publication of application: **10.11.2004**
(21) Application number: 04252482.7
(22) Date of filing: 29.04.2004
(51) Int. Cl.: H01L 33/00, H01L 23/44

(54) **Light emitting diode based light source with cooling liquid arrangement, and projection-type display apparatus**

(30) Priority: 06.05.2003 JP 2003128122; 26.08.2003 JP 2003301297
(71) Applicant: SEIKO EPSON CORPORATION, Tokyo 160-0811 (JP)
(72) Inventor: Nagata, Mitsuo Seiko Epson Corporation, Suwa-shi Nagano-ken 392-8502 (JP); Ikebe, Tomo Seiko Epson Corporation, Suwa-shi Nagano-ken 392-8502 (JP); Takeda, Takashi Seiko Epson Corporation, Suwa-shi Nagano-ken 392-8502 (JP)
(74) Representative: Cloughley, Peter Andrew

(57) **Abstract**

A light source apparatus includes a mounting substrate, at least one LED chip disposed on the mounting substrate, a liquid, and a sealed container for containing the mounting substrate, the at least one LED chip disposed thereon, and the liquid, wherein the LED chip is in direct contact with the liquid, and the sealed container has at least a part which is transparent to light emitted from the LED chip.

## Description

### BACKGROUND OF THE INVENTION

### Field of the Invention

The present invention relates to a light source apparatus and a method of manufacture therefor, and a projection-type display apparatus provided with this light source apparatus.

Priority is claimed on Japanese Patent Applications No. 2003-128122, filed May 6, 2003, and No. 2003-301297, filed August 26, 2003, the contents of which are incorporated herein by reference.

### Description of Related Art

The projection-type display apparatus (projector) includes a light source, an optical modulator for modulating light emitted from the light source based on an image signal, such as a liquid crystal panel, a digital micro-mirror device (DMD) and the like, and a projection lens for projecting the modulated light.

In recent years, projection-type display apparatuses have become smaller and of higher brightness, lifespan has been increased, and cost reduced. For example, in relation to the reduction in size, the size of the liquid crystal panel (the optical modulator) has been reduced from a diagonal dimension of 1.3 inches to 0.5 inches, and area has been reduced to slightly more than one sixth.

On the other hand, discharge-type lamps such as metal halide lamps, ultra-high pressure mercury lamps, and halogen lamps and the like are generally employed as the light source. For example, light sources using ultra-high pressure mercury discharge-type lamps require high-voltage power supply circuits, which are large and heavy, and thus hinder the reduction in size and weight of the projection-type display apparatus. Furthermore, while such lamps have a longer lifespan than halogen lamps, this lifespan is still short, light source control (rapid lighting, extinguishing and modulating of the lamp) is almost impossible, and moreover, an interval of a few minutes is necessary at start-up.

In recent years, these lamps have become smaller and brighter. Generation of heat has generally been associated with emission of light from these light sources, resulting in a change in the characteristics of the light source itself, and transfer of heat to the liquid crystal panel and optical components, and their deterioration with high temperature, and thus a variety of cooling devices for heat radiating devices have been considered. However, increased generation of heat from the light source is associated with progress in the reduction in size and increase in brightness of light source lamps, and it is becoming difficult to provide measures to deal with the generation of heat using the generally adopted fan-based forced cooling method. Therefore, as shown for example in Japanese Unexamined Patent Application, First Publication No. 2002-107825, a forced cooling method has been proposed wherein a liquid is employed in cooling the light source. The use of a liquid cooling method also has the advantage that noise associated with forced air cooling is reduced.

However, in Japanese Unexamined Patent Application, First Publication No. 2002-107825, a heat-collecting member is provided in a high-pressure mercury lamp serving as the light source, and the heat from the light source is absorbed by a liquid via the heat-collecting member, and the light source is thus cooled. That is, the heat from the light source is cooled indirectly, and cooling efficiency is insufficient. On the other hand, discharge lamps have common problems apart from heating which require resolution. For example, the lamp and power supply are large and heavy, and instantaneous lighting and extinguishing are not possible, and hence there is a requirement for improvement in terms of reduction in size, and improved performance, of projection-type display apparatus.

LED light sources have been proposed as a means to resolve the aforementioned problems of discharge light source lamps. LED light sources have advantages as light sources for projection-type display apparatuses, for example, LED light sources include a power supply and are small, they may be lit and extinguished instantaneously, they have wide color reproductivity, and have long lifespan. Furthermore, as they do not include toxic materials such as mercury, they are desirable from the point of environmental conservation.

At the same time, in order to use an LED light source in a projection-type display apparatus, the insufficient brightness of the light source requires a brightness of a level at least that of a discharge light source. This in turn requires resolution of the problems of (1) increasing output, and (2) reduced etendue.

The present invention resolves the aforementioned problems, with an object of providing a small and high-brightness light source apparatus suited to small projection-type display apparatuses.

### SUMMARY OF THE INVENTION

The first aspect of the present invention is a light source apparatus having a mounting substrate, at least one LED chip disposed on the mounting substrate, a liquid, and a sealed container for containing the mounting substrate, the at least one LED chip disposed thereon, and the liquid, wherein the LED chip is in direct contact with the liquid, and the sealed container has at least a part which is transparent to light emitted from the LED chip.

In current LEDs, the external quantum efficiency is low, and the majority of the supplied electrical energy is converted into heat. The amount of light emitted therefore normally increases with the current applied to the LED chip, while on the other hand, the amount of heat generated also increases considerably, so that the temperature of the LED chip increases and the efficiency with which light is emitted is reduced, and at the same time the LED chip itself is destroyed by the heat, thus preventing the use of large currents. As a result, present LEDs emit insufficient light for use as light sources for projection-type display apparatuses.

According to this aspect of the present invention, since the LED chip is cooled directly by the liquid, the heat generated by the LED chip is converted very efficiently, and as a result, it is possible to considerably increase the electric power supplied to the LED, and thus dramatically increase the amount of light emitted by the LED.

In the light source apparatus of the present invention, preferably a non-light emitting face side of the LED chip, opposite to a light emitting side, is exposed to the liquid for cooling.

Accordingly, cooling of the LED chip with the liquid occurs only for the non-emitting face side of the LED chip, and since the cooling liquid does not hinder the emitted light on the emitting face side, deterioration of image quality due to fluctuation of the liquid can be prevented with minimal interference with the direct cooling effect.

In the light source apparatus of the present invention preferably the sealed container comprises a cooling device for cooling the liquid contained therein.

Accordingly, the increase in temperature of the liquid due to absorption of the heat from the LED chip is maintained at a suitable liquid temperature with the use of the cooling device, and the capacity of the liquid to cool the LED chip can be maintained over a long period of time.

In the light source apparatus of the present invention, preferably the sealed container comprises a circulating device for circulating the liquid contained therein.

Accordingly, the cooling liquid constantly flows over the hot part of the LED chip by means of the circulating device, and heat is continuously transferred to the liquid. This furthermore stabilizes and maintains the cooling capacity of the liquid in relation to the LED chip.

In the light source apparatus of the present invention, preferably at least two LED chips are arranged in the thickness direction of the LED chips.

In order to make maximum effective use of the light source in the projection-type display apparatus, the etendue of the light source must be equal to or less than the etendue of the optical modulator. Here, "etendue" is a value expressing the spatial extent of the effectively useable luminous flux as a product of area and solid angle, and is maintained optically. As explained previously, since the liquid crystal panel (optical modulator) has been miniaturized, the etendue of the liquid crystal panel is reduced. The etendue of the light source is therefore also similarly reduced, and the projection-type display apparatus is able to be miniaturized, and it is possible to obtain a bright display.

According to the present invention, it is possible to reduce the etendue of the light source by lamination of the LED chips. For example, if the case in which an LED chip is divided into four so that the area of one part (emitted light area = light source etendue area) is one quarter and four layers are employed, is compared with the case in which one not divided LED chip is employed, then while the amount of light emitted is similar, in the former method the value is dependent upon the size and thickness of the LED chip and the chip spacing, and the etendue of the light source can be considerably reduced, and compared to the latter method, it is possible to make more effective use of the light from the LED chip. On the other hand, if a plurality of LED chips of the same area are laminated together, it is possible to increase the amount of emitted light approximately by a factor of the number of layers without significantly increasing the apparent surface area of the LED (the etendue of the light source is not significantly increased).

In the light source apparatus of the present invention, preferably the at least two LED chips are formed with separator parts mutually therebetween, and the separator parts are filled with the liquid.

Accordingly, each laminated LED chip is in direct contact with the cooling liquid and cooling efficiency is improved. As a result, the power applied to each LED chip can be increased, and it is possible to furthermore increase the amount of emitted light.

In the light source apparatus of the present invention, a reflective film may be provided on the surface of the LED chip farthest from a light emitting section of the sealed container. Moreover, a reflective plate may be provided parallel to the at least two of LED chips, on the side of the LED chip farthest from the light emitting face of the sealed container.

Accordingly, since light emitted from the laminated LED chips is emitted to the exterior as light having the amount of emitted light of the number of laminated LED chips, it is possible to increase the amount of emitted light efficiently with a simple configuration.

The second aspect of the present invention is a projection-type display apparatus having the aforementioned light source apparatus, an optical modulator for modulating light from the light source apparatus, and a projection lens for projecting modulated light from the optical modulator.

Accordingly, the light source apparatus of the present invention has a mounting substrate, an LED chip positioned on the mounting substrate, and a sealed container filled with liquid, and is of a configuration wherein the LED chip is cooled directly by the liquid, and at least part of the sealed container is transparent to light from the LED chip. As a result, extremely bright light from the small light source is emitted. Since the etendue of the light source is appropriate, the emitted light is effectively acquired in the optical modulator, and the modulated light is projected onto the screen with the lens as a bright image. As a result a small and high-brightness projection-type display apparatus can be obtained.

A third aspect of the present invention is a light source apparatus has a base, a solid-state light source mounted on the base, a cooling fluid, a device for cooling the solid-state light source by a cooling fluid in direct, and a protective film including a transparent insulating material on an external surface having electrodes of the solid-state light source, for covering completely at least a surface of the solid-state light source exposed to the cooling fluid.

In the present invention, a protective film is provided for the solid-state light source and the electrodes of the solid-state light source to prevent deterioration of the solid-state light source due to chemical reaction with the cooling fluid, and shorting or the like between the electrodes via the fluid. The structure disclosed in Japanese Unexamined Patent Application, First Publication No. Hei 7-202269 is an example of such provision of a protective film for the solid-state light source. However, this technology has as its purpose the alleviation of thermal stresses occurring in the process of manufacturing solid-state light sources on substrates, and the protective film is formed prior to bonding of the electrodes. During bonding, therefore, it is necessary to remove the protective film from the electrodes, and shorting between the electrodes via the fluid cannot be prevented. Conversely, in the present invention, the protective film is also provided on the electrodes of the solid-state light source, and since the entire outer face of the solid-state light source of the part exposed to the cooling fluid (including the electrodes of the solid-state light source) is covered by the protective film, such electrical shorting can be reliably prevented.

Furthermore, with this configuration, the solid-state light source (including the electrodes) is completely separated from the cooling fluid. Therefore there is no deterioration due to chemical reaction between these components and the cooling fluid.

Moreover, when a protective film is positioned between the fluid and the solid-state light source in this manner, the temperature variation (temperature gradient) occurring at the interface with the fluid is partially absorbed by the protective film. Therefore, the temperature gradient occurring at the surface of the solid-state light source is smaller than in the case of there being no protective film. The thermal stress occurring between the layers of the solid-state light source can therefore be alleviated in comparison with the conventional case, and the lifespan of the device can be extended.

Furthermore, with this configuration, since the electrode part of the solid-state light source is covered with the protective film, the joins of the electrodes can be fastened in place, and the reliability of the device can therefore be improved. In particular, in structures mounted due to face-up package and wire-bonded, the joins between the solid-state light source electrodes and the wire readily peel due the pressure of the fluid, and the advantages of the present invention are therefore considerable.

In the present invention, preferably the protective film is provided so as to cover the surface of the base exposed to the fluid.

In this manner, a protective film is provided so that not only the solid-state light source, but also the surface of the base supporting the solid-state light source, is covered, and hence changes in, and corrosion of, the base due to the aforementioned chemical reaction with the cooling fluid can be prevented. Moreover, if the base is of metal, a configuration is assumed whereby the base itself is employed as the electrodes of the solid-state light source. In this case as well, by covering of the surface of the base with the protective film as in the present invention, it is possible to reliably prevent shorting between the electrodes and the base, or between the bonding wires (with face-up package) and the base.

Furthermore, preferably the protective film has an inorganic material.

An organic material may also be employed in the aforementioned protective film, however when the intensity of the light emitted increases, the protective film itself deteriorates due to the emitted light, and this may result in reduced insulation and transparency. Reliability of the device can therefore be improved by the use of a protective film of an inorganic material which does not deteriorate with exposure to light.

Moreover, in the present invention, preferably the protective film has a laminated film of a plurality of insulating films having mutually differing refractive indices, and the plurality of insulating films are laminated together in order of increasing refractive index in relation to the solid-state light source.

Since the material including the solid-state light source is normally material having a high refractive index (for example, a refractive index of approximately 3), direct exposure of this material to the fluid (having, for example, a refractive index of approximately 1.5) will result in the majority of the light emitted being completely reflected at the interface between the solid-state light source and the fluid. The light reflected in this manner not only does not contribute to illumination, but is also converted to heat, and is therefore a factor in deterioration of the light emitting characteristics of the device. Therefore, in order to raise the efficiency with which light is extracted, it is necessary to position a material having an intermediate refractive index (the protective film forms this intermediate material in the present invention) between the solid-state light source and the fluid. However, as explained above, since the difference in refractive index between the solid-state light source and the fluid is very large, sufficient effect cannot be obtained with a single-layer film between the solid-state light source and the fluid. It is therefore desirable that the protective film be designed as a laminated film of film materials in order of decreasing refractive index from the solid-state light source side. By gradually varying the refractive index from the solid-state light source side to the fluid side in this manner, the critical angle at which full reflection occurs increases at each interface (interface between the solid-state light source and the insulating film, interface between adjacent insulating films, and interface between the insulating film and the fluid), and the proportion of light completely reflected is small, that is, the efficiency with which light is extracted increases.

The thickness and number of layers of the insulating film positioned between the solid-state light source and the fluid can be determined freely in terms of insulation performance, heat dissipation, and productivity and the like. However, sufficient performance can be demonstrated with a laminated film of approximately three layers without loss of productivity. For example, when the aforementioned protective film is a laminated film laminated from first, second, and third layers of insulating film in order from the solid-state light source side, it is possible for light to be efficiently extracted by using, for example at least one of TiO₂, Ta₂O₅, ZnO, and ZrO₂ in the first insulating film, at least one of MgO and Al₂O₃ in the second insulating film, and at least one of SiO₂ and MgF₂ in the third insulating film. Each insulating film may be comprised of a single material, or of a number of the aforementioned materials.

Furthermore, in the present invention, preferably the cooling fluid has an inorganic material.

An organic material may also be employed as the cooling fluid. However, when the intensity of the light emitted increases, the cooling fluid itself may deteriorate due to the emitted light. Moreover, this deterioration further increases when a material having a photocatalytic effect on the protective film (for example, TiO₂) is employed. The reliability of the device can therefore be improved by the use of a cooling fluid having inorganic material which does not deteriorate with exposure to light.

Furthermore, in the present invention, preferably the cooling fluid is a liquid material. Naturally, a gas (for example an inert gas such as nitrogen) can be employed as the fluid. However the efficiency of heat dissipation can be raised by use of a liquid material (for example, silicon oil) having a high thermal conductivity.

Moreover, in the present invention, the thickness of the protective film can be determined as desired in terms of insulation performance and heat dissipation. However, the advantages of the present invention can be sufficiently obtained with a film thickness of greater than 0.8 µm and less than 1.5 µm.

Furthermore, a method of manufacturing a light source apparatus in which a solid-state light source is cooled directly by a fluid, the method having, a mounting step for mounting the solid-state light source on a base, and a protective film formation step for forming a transparent protective film including an insulating material on an external surface having electrodes of the mounted solid-state light source, so that at least a surface of the solid-state light source exposed to the fluid is completely covered.

In this method of manufacture, the protective film is formed following mounting of the solid-state light source, and covers the entire face exposed to the cooling fluid, of the solid-state light source (including electrodes). For example, in the device disclosed in Japanese Unexamined Patent Application, First Publication No. Hei 7-202269, since the protective film is formed prior to the mounting process, the protective film positioned above the electrodes must be removed when mounting. The aforementioned advantages of the light source apparatus of the present invention (that is, prevention of deterioration of the solid-state light source due to chemical reaction with the fluid, alleviation of thermal stress occurring in the vicinity of the surface of the solid-state light source during cooling, prevention of shorting between electrodes via the fluid, and improved bonding strength) are therefore not obtained at least in these electrode parts. On the other hand, with this method, since the protective film can also be provided on the electrodes of the solid-state light source, the external surface of the part of the solid-state light source exposed to the cooling fluid is covered entirely by the protective film, and the aforementioned advantages can be reliably obtained.

In the protective film formation step, preferably the protective film is formed so as to cover the face of the base exposed to the fluid.

In this manner, not only the solid-state light source, but the surface of the base supporting the solid-state light source, are covered by the protective film, and the aforementioned changes in, and corrosion of, the base due to chemical reaction with the cooling fluid can be prevented. Furthermore, if the base is of metal, a configuration is possible whereby this base itself is employed as the electrodes of the solid-state light source. In this case as well, by covering of the surface of the base with the protective film as in the present invention it is possible to reliably prevent shorting between the electrodes and the base, or between the bonding wires (with face-up package) and the base.

Moreover, preferably the protective film is formed from an inorganic material. This enables deterioration of the protective film due to the light emitted by the solid-state light source to be prevented.

Furthermore, preferably in the protective film formation step, at least a protective film positioned on an interface with the solid-state light source is formed by a vacuum deposition method.

A variety of film formation methods such as vacuum deposition methods (for example, the spatter method, the plasma CVD method, the EB vacuum deposition method) and liquid application methods (for example, the sol-gel method, the SOG (Spin On Glass) method) can be employed. However, in comparison with films formed with liquid application methods (liquid application films), films formed with vacuum deposition methods (vacuum deposited films) are superior in terms of homogeneity and density. Therefore, in cases such as with the present invention wherein a high level of insulation performance is required in the protective film, vacuum deposition methods are more suitable than liquid application methods.

Moreover, preferably in the protective film formation step, the protective film is formed by a rotating oblique vacuum deposition method (that is, a method wherein the insulating material is vacuum deposited from an oblique direction in relation to the light source, while the base is being rotated).

According to this method, a homogeneous film can be formed on the entire surface of the light source. In particular, when wire is bonded to a light source mounted due to face-up package, there is the possibility that the protective film may not be sufficiently formed in the part in the shadow of the bonding wire. However, this problem can be avoided with use of this method. Furthermore, with semiconductor light emitting devices such as LEDs and the like, in order to raise the efficiency with which light is extracted, a structure wherein a depression is provided in the base (for example, a depression having a tapered slope wherein the area of the opening increases with distance from the surface of the base), and within which the solid-state light source is positioned, has already been developed. However, when the rotating oblique vacuum deposition method is applied to this structure, a protective film of sufficient thickness can also be formed on the interior wall surface of the depression.

Moreover, preferably in the protective film formation step, the protective film is formed laminated with a plurality of insulating films having mutually differing refractive indices in order of increasing refractive index. As a result the efficiency with which the emitted light can be extracted can be improved.

Furthermore, when in the mounting step the solid-state light source is mounted in the base by a face-down package (flip-chip package), then preferably in the protective film formation step at least part of the protective film is formed by a liquid application method.

As explained above, in forming the protective film, the vacuum deposition method is suited to the formation of a more dense protective film. However, when a very small gap occurs between the solid-state light source and the base, as is the case with a face-down package, a sufficient film cannot be formed in this gap with the vacuum deposition method. In such cases, therefore, a liquid application method is suited to formation of a film also in the small gap.

However, since the applied film presents problems in terms of density, then it is preferable to adopt a method wherein, for example, the protective film is formed as a plurality of laminated insulating films, and one part of the insulating films is formed by a liquid application method, and the other insulating films are formed by a vacuum deposition method. In this case, in order to reliably protect the solid-state light source by a dense film, it is preferable to form the insulating film positioned closest to the solid-state light source side by a vacuum deposition method, and form the insulating film positioned farthest from the solid-state light source side by a liquid application method. Moreover, when in this way, part of the protective film is formed by the liquid application method, then preferably the thickness of the part of the protective film formed by the liquid application method is less than 0.3 µm, in order to prevent development of cracks.

Furthermore, a fourth aspect of the present invention is a projection-type display apparatus having the aforementioned light source apparatus, an optical modulator for modulating light emitted from the light source apparatus, and a projection lens for projecting the modulated light.

According to this configuration, by providing the aforementioned light source apparatus, it is possible to provide a brighter and highly reliable projection-type display apparatus.

### BRIEF DESCRIPTION OF THE DRAWINGS

FIG. 1 is a schematic perspective view of a light source apparatus 110 in a first embodiment.
FIG. 2 is a sectional view of the light source apparatus 110 in the first embodiment.
FIG. 3A and FIG. 3B are plan and sectional views respectively of an LED chip 10 and a mounting substrate 20.
FIG. 4 is a sectional view of a light source apparatus 110 in FIG. 1 in a second embodiment.
FIG. 5 is a schematic plan view of a light source apparatus 120 in a third embodiment.
FIG. 6 is a sectional view of the light source apparatus 120 in FIG. 5.
FIG. 7 is a sectional view of the light source apparatus 120 in FIG. 5 in a fourth embodiment.
FIG. 8 is a schematic plan view of the light source apparatus 120 in a fifth embodiment.
FIG. 9A and FIG. 9B are plan and sectional views respectively of the LED chip 15 and the mounting substrate 20 in FIG. 8.
FIG. 10 is a sectional view of the light source apparatus 120 in FIG. 8.
FIG. 11 is a sectional view of the light source apparatus 120 in a sixth embodiment.
FIG. 12 is a sectional view of the light source apparatus 120 in the sixth embodiment.
FIG. 13 is a schematic block diagram of an optical system of a projection-type display apparatus 1 in a seventh embodiment.
FIG. 14 is a schematic block diagram of an optical system of a projection-type display apparatus 2 in an eighth embodiment.
FIG. 15 is an outline sectional view of a light source apparatus 150 in a ninth embodiment.
FIG. 16 is an enlarged sectional view showing the configuration of the primary components of the light source apparatus 150 in FIG. 15.
FIG. 17A to FIG. 17C are process drawings for explaining a method of manufacture of the light source apparatus 150 in FIG. 15.
FIG. 18 is a schematic sectional view of a light source apparatus 150 in a tenth embodiment.
FIG. 19 is a schematic sectional view of a light source apparatus 150 in an eleventh embodiment.
FIG. 20 is a schematic block diagram of an optical system of a projection-type display apparatus 3 in a twelfth embodiment.

### DETAILED DESCRIPTION OF THE INVENTION

The following explains the embodiments of the present invention with reference to the drawings.

### (First embodiment)

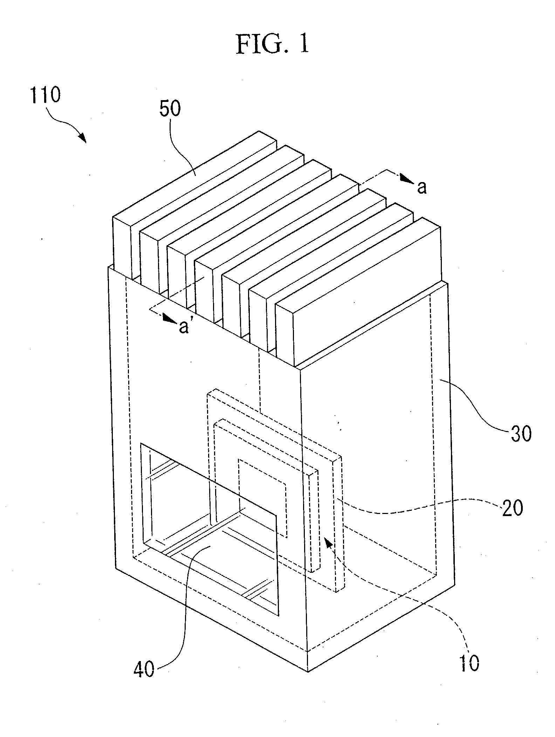

A first embodiment relates to a light source apparatus, and is explained based on FIG. 1 through FIG. 3.

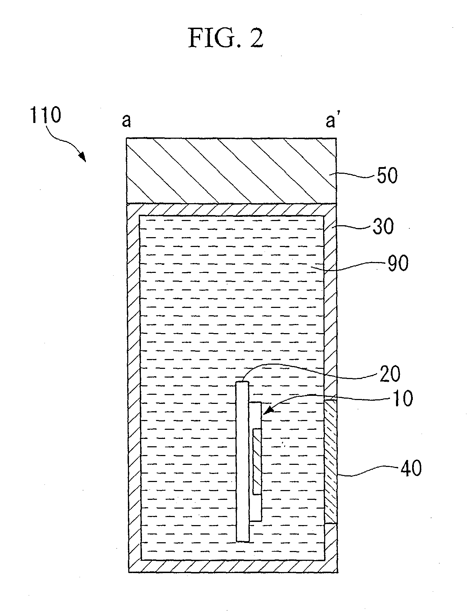

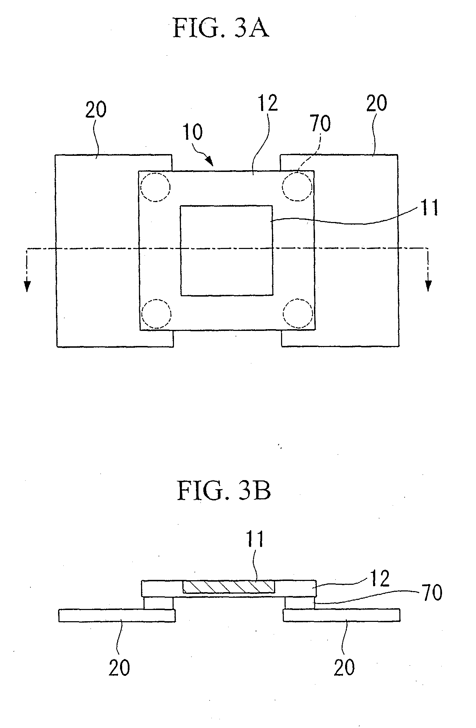

FIG. 1 is a schematic perspective view of a light source apparatus 110 of the present embodiment. FIG. 2 is a sectional view of the light source apparatus 110 in FIG. 1. FIG. 3A and FIG. 3B are plan and sectional views respectively of an LED chip 10 and a mounting substrate 20 constituting the light source apparatus 110 in FIG. 1.

As shown in FIG. 1, the light source apparatus 110 of the present embodiment includes the LED chip 10, the mounting substrate 20, a sealed container 30, a transparent window 40, and cooling fins 50. As shown in FIG. 2, the sealed container 30 is filled with a liquid 90, and the LED chip 10 and the mounting substrate 20 are completely immersed in the liquid 90. Moreover, as shown in FIG. 3, the LED chip 10 comprises an LED light emitting region 11 and an LED substrate 12. In the present embodiment, a transparent sapphire substrate is employed as the LED substrate. The LED chip 10 is connected and fastened to the mounting substrate 20 via conductive pads 70.

In order to simplify the explanation, parts securing the sealed container 30 and the mounting substrate 20, the electrode wiring and power supply circuit for lighting the LED chip 10, and the filler inlet for filling the liquid 90 into the sealed container 30, are not shown in FIG. 1 through FIG. 3B.

The material employed for the sealed container 30 may be selected from metal, glass, or plastic and the like. It is desirable that it be at least a chemically stable material in relation to the enclosed liquid 90. When glass or transparent plastic (for example, acrylic plastic or polycarbonate) are employed, the transparent window 40 can be dispensed with in some applications.

The transparent window 40 is a transparent and chemically stable material in relation to the liquid 90, and has an optical functionality permitting extraction of the light emitted from the LED chip 10 to the outside of the sealed container 30 without waste. For example, glass or transparent plastic (for example, acrylic plastic or polycarbonate) is formed into a shape which does not block the light emitted from the LED chip 10. Furthermore, a suitable device such as ordinary adhesive or screws and the like is employed in fastening the transparent window 40 to the sealed container 30 to ensure that the liquid does not leak.

The cooling fins 50 are formed from metal including iron, copper, aluminum, or magnesium and the like, or a material including these metals and having superior thermal conductivity. As shown in FIG. 1, the cooling fins 50 include a multiplicity of fins to ensure a large surface area and thus increase the ability to dissipate heat to the exterior. In the present embodiment, the cooling fins 50 are fastened to one surface of the external surface of the sealed container 30 by a suitable device, so as not to impair the transfer of heat from the sealed container 30. However, they may also be provided on the other plural external surfaces. Moreover, they may also be formed integrally with part of the sealed container 30. Furthermore, if natural convection of the air between the fins is insufficient to dissipate the heat, provision of an electric cooling fan for forced air convection can be employed to increase the ability to dissipate heat.

The liquid 90 is a transparent liquid. Preferably this is electrically insulating, and is selected from liquids which are non-corrosive in relation to the materials provided in the light source apparatus 110. More preferably this has a low vapor pressure, a low freezing point, superior stability, and high thermal conductivity. Examples of liquids suitable for application in the present invention are liquids in general use such as biphenyl diphenylether, alkylbenzene, alkylbiphenyl, triaryl-dimethane, alkylnapthalene, hydrogenated terphenyl, and diarylalkane-type organic heat transfer media. Moreover, silicone and fluorinated liquids are also suitable. The liquid employed is selected from the aforementioned liquids, in consideration of the use of the light source apparatus, required performance, and environmentally friendly qualities and the like.

In the configuration of the aforementioned present embodiment, heat produced when the LED chip 10 is lit is cooled extremely efficiently due to the surface of the LED chip 10, which is the heat source, being in direct contact with the liquid 90. The heated liquid 90 moves to the top of the sealed container 30 by natural convection. The heat of the liquid 90 moving to the top of the sealed container is transferred to the cooling fins 50 via the walls of the sealed container 30. The heat transferred to the cooling fins 50 is transferred to the exterior by, for example, heat exchange with the air. The liquid 90 is cooled efficiently via these heat transfer paths. The cooled liquid 90 descends and is employed repeatedly in cooling of the LED chip 10. In the present embodiment, the cooling fins 50 are provided to enhance cooling. However, it is also possible to dispense with the cooling fins 50 depending upon the application of the light source apparatus 110 and the conditions of use.

As explained above, according to the present embodiment, since the LED chip 10 is cooled directly by the liquid 90, the temperature increase of the LED chip 10 can be controlled. As a result, it is possible to considerably increase the electric power supplied to the LED chip 10, and hence the amount of light emitted can be dramatically increased.

### (Second embodiment)

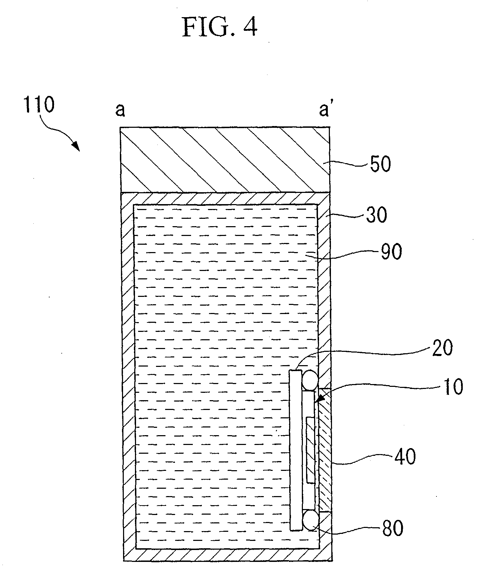

A second embodiment relates to a modified example of the light source apparatus 110 explained in the first embodiment, and is explained based on FIG. 4.

FIG. 4 is a sectional view of the light source apparatus 110 of the present embodiment. The present embodiment differs from the first embodiment in that, in the first embodiment, the LED chip 10 is completely immersed in the liquid 90 and is cooled directly. However, in the second embodiment, the LED chip 10 is positioned so that the surface on the side from which light is emitted from the LED chip 10 is not immersed in the liquid 90. The same reference symbols are employed for parts the same as in the first embodiment, and explanation of the configuration is omitted.

In FIG. 4, the LED chip 10 connected and fastened to the mounting substrate 20 is positioned so that the face on the side from which light is emitted faces the transparent window 40, and is fastened to the inner face of the sealed container 30 via an elastic member 80. The elastic member 80 is of elastic sealing material or rubber packing and the like selected to function to ensure that the liquid 90 does not enter the light emitting face side of the LED chip 10.

In the aforementioned configuration of the present embodiment, heat produced when the LED chip 10 is lit is cooled efficiently by directly contacting the non light emitting face side of the LED chip 10, which is the heat source, with the liquid 90. In comparison with the first embodiment, the cooling efficiency is reduced. However, as with the first embodiment, this is a dramatically improved cooling device in comparison to the forced air cooling methods of the conventional technology. The heated liquid 90 moves to the top of the sealed container 30 by natural convection. The heat of the liquid 90 moving to the top of the sealed container is transferred to the cooling fins 50 via the container walls of the sealed container 30. The heat transferred to the cooling fins 50 is transferred to the exterior by, for example, heat exchange with the air. The liquid 90 is cooled efficiently via these heat transfer paths. The cooled liquid 90 descends and is employed repeatedly in cooling of the LED chip 10. In the present embodiment, cooling fins 50 are provided to enhance cooling. However it is also possible to dispense with cooling fins 50 depending upon the application of the light source apparatus 110 and the conditions of use.

Furthermore, the different effect of the present embodiment to the first embodiment is that, since the light emitting face of the LED chip 10 is not immersed in the liquid 90, the phenomenon of fluctuation due to the liquid 90 can be almost completely eliminated. When the first embodiment is implemented, some conditions of use may give rise to the phenomenon of fluctuation due to the liquid 90, resulting in problems with quality of the light source. This problem is resolved completely with the present embodiment.

### (Third embodiment)

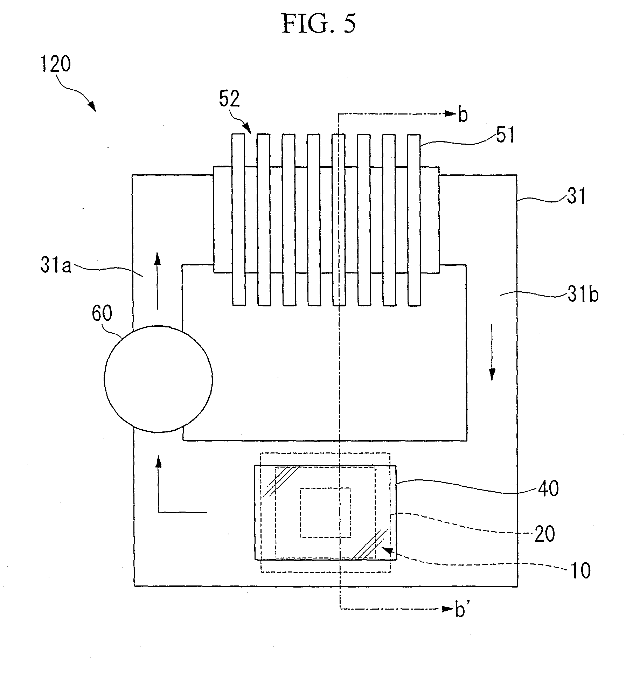

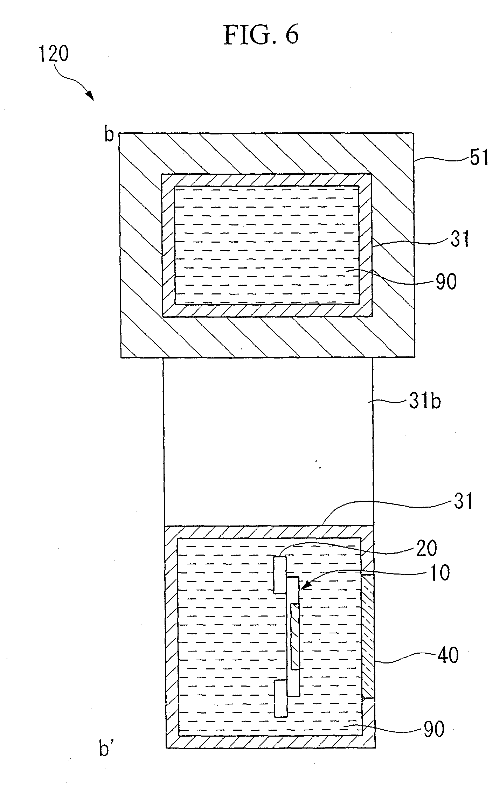

A third embodiment of the present invention explains the light source apparatus 120 based on FIG. 5 and FIG. 6. The third embodiment differs from the first and second embodiments in that in the third embodiment the liquid 90 is forcibly circulated. FIG. 5 is a schematic plan view of the light source apparatus 120 of the present embodiment. FIG. 6 is a sectional view of FIG. 5. The same reference symbols are employed for parts the same as in the first and second embodiments, and explanation of the configuration is omitted.

As shown in FIG. 5, in the light source apparatus 120 of the present embodiment, an LED chip 10, a mounting substrate 20, a transparent window 40, a cooling fins 51, and a circulation pump 60 are positioned at a prescribed position on a ring-shaped sealed container 31. The interior of the sealed container 31 is filled with liquid 90. The liquid 90 is forcibly circulated within the container via liquid circulation paths 31a and 31b by a circulation pump 60 provided with the sealed container 31. The cooling fins 51 are positioned between the liquid circulation paths 31a and 31b of the ring-shaped sealed container 31. The basic configuration and functions are the same as for the cooling fins 50 of the first embodiment. As shown in FIG. 6, the LED chip 10 and the mounting substrate 20 positioned within the sealed container 31 are completely immersed in the liquid 90. Other configurations are the same as for the first embodiment and therefore explanation is omitted.

In order to simplify the explanation, parts securing the sealed container 31 and the mounting substrate 20, the electrode wiring and power supply circuit for lighting the LED chip 10, the circulation pump 60 power supply, and the filler inlet for filling the liquid 90 into the sealed container 30, are not shown in FIG. 5 and FIG. 6.

In the aforementioned configuration of the present embodiment, heat produced by lighting of the LED chip 10 is cooled extremely efficiently due to the surface of the LED chip 10 being the heat source, being in direct contact with the liquid 90. The heated liquid 90 is fed to the cooling fin part 52 by the circulation pump 60 via the liquid circulation path 31a. In the cooling fin part 52, the heat from the liquid 90 is transferred to the cooling fins 51 through the container wall of the sealed container 31. The heat transferred to the cooling fins 51 is transferred to the exterior by, for example, heat exchange with the air. The liquid 90 is cooled efficiently via these heat transfer paths. The cooled liquid 90 is employed repeatedly in cooling of the LED chip 10 via the liquid circulation path 31b.

In the present embodiment, the cooling fins 51 are provided to enhance cooling. However, it is also possible to dispense with the cooling fins 51 depending upon the application of the light source apparatus 120 and the conditions of use.

As explained above, according to the present embodiment, since the LED chip 10 is cooled continuously and directly by the liquid 90 circulated by the circulation pump 60 and cooled by the cooling fins 51, the temperature increase of the LED chip 10 can be controlled more effectively. As a result, it is possible to considerably increase the electric power supplied to the LED chip 10, and the amount of light emitted by the LED can be increased.

### (Fourth embodiment)

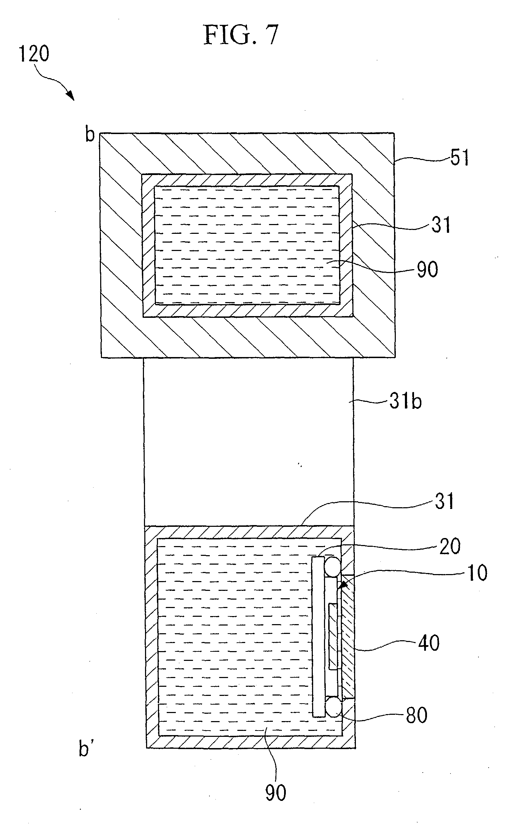

A fourth embodiment of the present invention relates to a modified example of the light source apparatus 120 explained in the third embodiment, and is explained based on FIG. 7.

FIG. 7 is a sectional view of the light source apparatus 120 in FIG. 5 in the present embodiment. The present embodiment differs from the third embodiment in that, in the third embodiment, the LED chip 10 is completely immersed in the liquid 90 and is cooled directly. However, in the fourth embodiment the LED chip 10 is positioned so that the face on the side from which light is emitted from the LED chip 10 is not immersed in the liquid 90. The same reference symbols are employed for parts the same as in the third embodiment, and explanation of the configuration is omitted.

In the present embodiment in FIG. 7, the LED chip 10 connected and fastened to the mounting substrate 20 is positioned so that the face on the side from which light is emitted faces the transparent window 40, and is fastened to the inner face of the sealed container 31 via an elastic member 80. The elastic member 80 is of elastic sealing material or rubber packing and the like selected to function to ensure that the liquid 90 does not enter the light emitting face side of the LED chip 10.

In the aforementioned configuration of the present embodiment, heat produced when the LED chip 10 is lit is cooled efficiently by directly contacting the non light emitting face side of the LED chip 10, which is the heat source, with the liquid 90. In comparison with the third embodiment, the cooling efficiency is reduced. However, as with the third embodiment, this is a dramatically improved cooling device in comparison to the forced air cooling methods of the conventional technology. The heated liquid 90 is fed to the cooling fin part 52 by the circulation pump 60 via the liquid circulation path 31a. In the cooling fin part 52, the heat from the liquid 90 is transferred to the cooling fins 51 via the container wall of the sealed container 31. The heat transferred to the cooling fins 51 is transferred to the exterior by, for example, heat exchange with the air. The liquid 90 is cooled efficiently via these heat transfer paths. The cooled liquid 90 is employed repeatedly in cooling of the LED chip 10 via the liquid circulation path 31b.

In the present embodiment, the cooling fins 51 are provided to enhance cooling. However it is also possible to dispense with cooling fins 51 depending upon the application of the light source apparatus 120 and the conditions of use.

As explained above, according to the present embodiment, since the LED chip 10 is cooled continuously and directly by the liquid 90 circulated by the circulation pump 60 and cooled by the cooling fins 51, the temperature increase of the LED chip 10 can be controlled more effectively. As a result, it is possible to considerably increase the electric power supplied to the LED chip 10, and the amount of light emitted by the LED can be increased.

Moreover, the different effect of the present embodiment to the third embodiment is that, since the light emitting face of the LED chip 10 is not immersed in the liquid 90, the phenomenon of fluctuation due to the liquid 90 can be almost completely eliminated. When the third embodiment is implemented, some conditions of use may give rise to the phenomenon of fluctuation due to the liquid 90, resulting in problems with quality of the light source. This problem is resolved completely with the present embodiment.

### (Fifth embodiment)

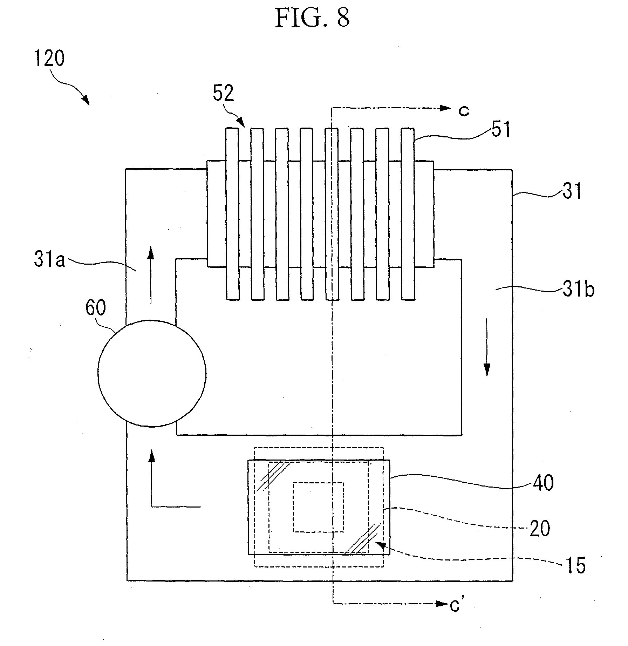

A fifth embodiment of the present invention relates to a light source apparatus, and is explained based on FIG. 8 to FIG. 10.

The fifth embodiment differs from the first through fourth embodiments in that in the fifth embodiment a plurality of LED chips are laminated together.

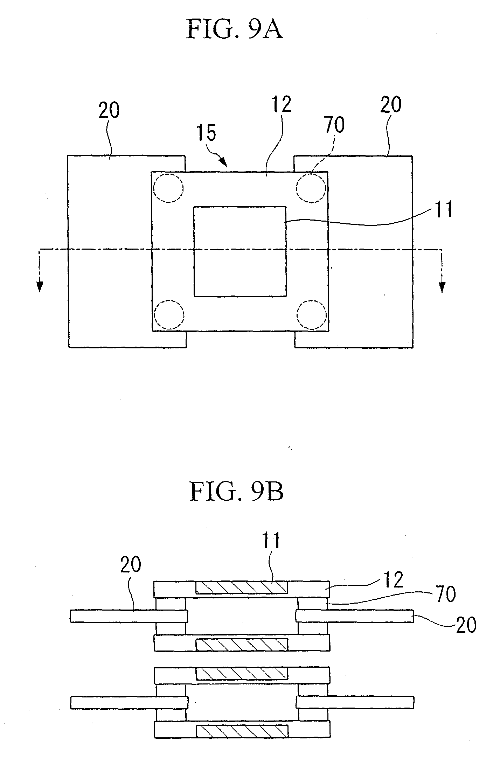

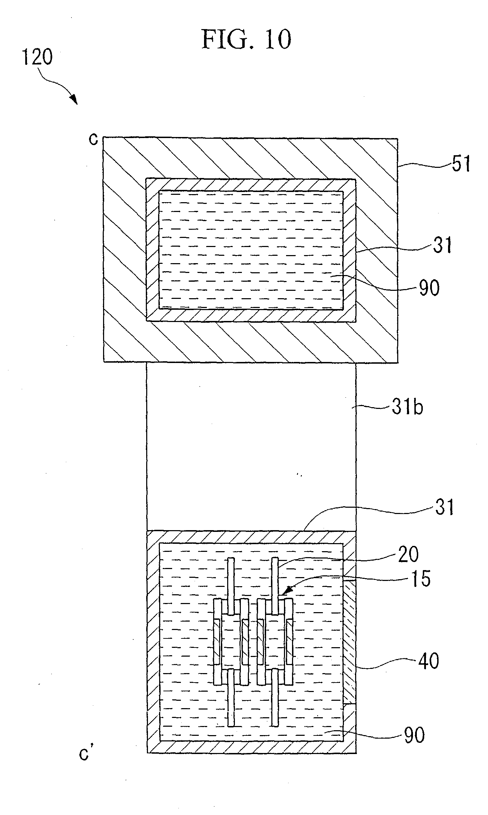

FIG. 8 is a schematic plan view of the light source apparatus 120 of the present embodiment. FIG. 9A and FIG. 9B are plan and sectional views respectively of the laminated LED chips 15 and the mounting substrates 20 constituting the light source apparatus 120 in FIG. 8. FIG. 10 is a sectional view of FIG. 8. The same reference symbols are employed for parts the same as in the first through fourth embodiments, and explanation of the configuration is omitted.

As shown in FIG. 8, in the light source apparatus 120 of the present embodiment there is provided laminated LED chips 15. Other configurations are the same as in the third embodiment, and explanation is thus omitted.

As shown in FIG. 9A and FIG. 9B, the LED chip 15 comprises an LED light emitting region 11 and an LED substrate 12. In the present embodiment, a transparent sapphire substrate is employed as the LED substrate. The LED chip 15 is connected and fastened to the mounting substrate 20 via conductive pads 70. In FIG. 9B, as an example, the LED chip 15 is in four laminations facing each other. The four laminated LED chips 15 are positioned away from each other so that the liquid 90 is in direct contact with each of the LED chip surfaces, and with a spacing to allow movement of the liquid 90 between the LED chips. The light emitted from the LED light emitting region 11 is emitted primarily in the direction of the face. In the present embodiment, since the LED substrate 12 is a transparent sapphire substrate, light is emitted from both faces of the LED light emitting region.

As shown in FIG. 10, the plurality of laminated LED chips 15 and the mounting substrate 20 are completely immersed in the liquid 90.

In order to simplify the explanation, parts securing the sealed container 31 and the mounting substrate 20, a joining part joining each of the plurality of laminated mounting substrates 20, the electrode wiring and power supply circuit for lighting the LED chips 15, the circulation pump 60 power supply, and the filler inlet for filling the liquid 90 into the sealed container 30, are not shown in FIG. 8 through FIG. 10.

In the aforementioned configuration of the present embodiment, four LED chips 15 of the same area are laminated together, the area from which the light is emitted is approximately the same as for one, and it is possible to increase the amount of light emitted by a factor of four. Furthermore, the heat produced by lighting the laminated LED chips 15 is cooled extremely efficiently since the liquid 90 is in direct contact with the surface of each LED chip 15, being the heat source. Since the laminated LED chips 15 are mutually separated at a suitable spacing, the liquid 90 is constantly in direct contact with the surface of the LED chips 15, forming a reliable cooling device. The heated liquid 90 is fed to the cooling fin part 52 by the circulation pump 60 via the liquid circulation path 31a. In the cooling fin part 52, the heat from the liquid 90 is transferred to the cooling fins 51 through the container wall of the sealed container 31. The heat transferred to the cooling fins 51 is transferred to the exterior by, for example, heat exchange with the air. The liquid 90 is cooled efficiently via these heat transfer paths. The cooled liquid 90 is employed repeatedly in cooling of the LED chips 15 via the liquid circulation path 31b.

In the present embodiment, the cooling fins 51 are provided to enhance cooling. However, it is also possible to dispense with the cooling fins 51 depending upon the application of the light source apparatus 120 and the conditions of use.

As explained above, according to the present embodiment, a plurality of LED chips 15 are laminated together and thus the area from which the light is emitted is approximately the same as for one, and it is possible to increase the amount of light emitted by a multiple factor. Moreover, since each laminated LED chip 15 is cooled continuously and directly by the liquid 90 circulated by the circulation pump 60, the temperature increase of each LED chip 15 can be controlled effectively. Furthermore, since the laminated LED chips 15 are mutually separated at a suitable spacing, the liquid 90 is constantly in direct contact with the surface of the LED chips 15, and the LED chips 15 are cooled reliably and efficiently. As a result, it is possible to considerably increase the electric power supplied each LED chip 15, and hence the amount of light emitted can be further increased.

The present embodiment has been explained for the light source apparatus 120. However, the same effect is obtained with the light source apparatus 110.

### (Sixth embodiment)

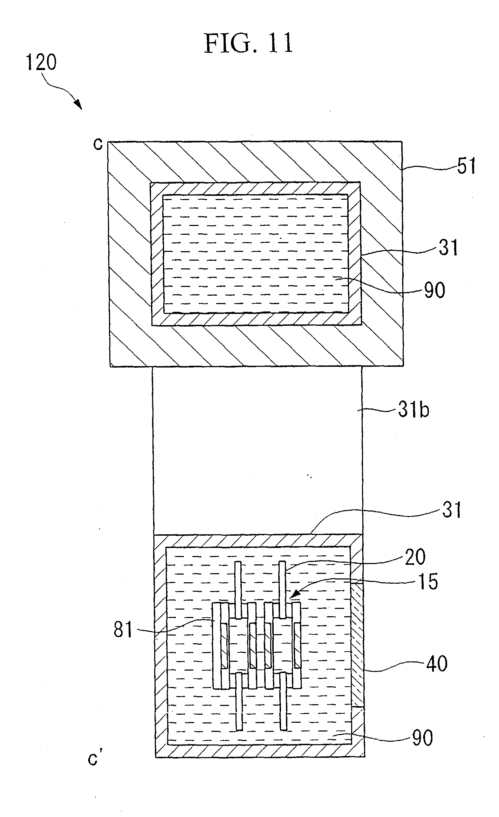

A sixth embodiment of the present invention relates to a light source apparatus, and is explained based on FIG. 11.

FIG. 11 is a sectional view of the light source apparatus 120 of the present embodiment.

As shown in FIG. 11, the light source apparatus 120 of the sixth embodiment differs from the fifth embodiment in that in the sixth embodiment a reflective film 81 is provided on the LED chip 15 surface (surface on the opposite side to the transparent window 40 in the embodiment) farthest from the surface of the sealed container 30 from which light is emitted.

The same reference symbols are employed for parts the same as in the first through fifth embodiments, and explanation of the configuration is omitted.

In the fifth embodiment, the light emitted from the LED light emitting region 11 is primarily emitted in the face direction. On the other hand, in the present embodiment, since the reflective film 81 is provided on the LED chip 15 surface farthest from the face of the sealed container 30 from which light is emitted, the emitted light is emitted in one direction (transparent window 40 side in the embodiment).

Consequently, according to the configuration of the present embodiment, since the light emission light from each laminated LED chip is emitted to the exterior from the predetermined emitting surface as light having a light emission amount of the number of layers, it is possible to increase the amount of projected light efficiently with a simple configuration.

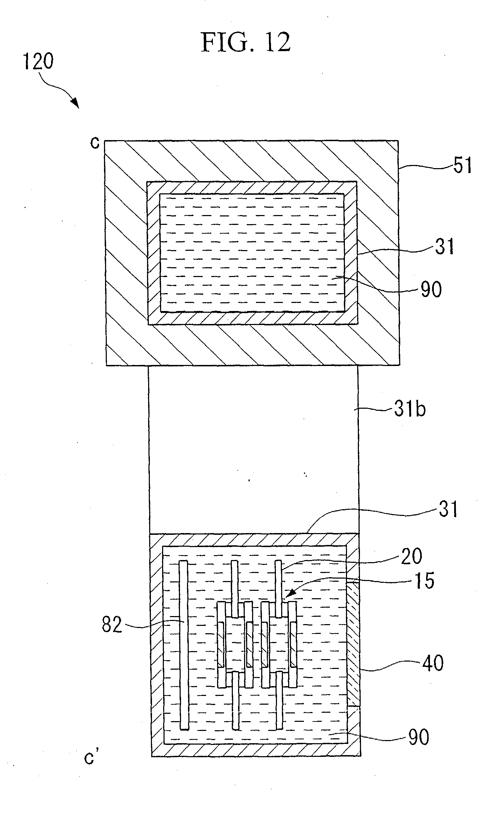

The present embodiment is not restricted to the aforementioned configuration, and for example, as shown in FIG. 12, in place of the reflecting film 81 as shown in FIG. 11, a reflective plate 82 can be provided in parallel with the LED chip 15 on the side of the LED chip farthest from the surface of the sealed container 30 from which the light is emitted. In this case, preferably the outside diameter of the reflective plate is approximately that of the mounting substrate 20. Accordingly, the same operation and effect is obtained as with the aforementioned reflective film 81.

The present embodiment has been explained for the light source apparatus 120. However, the same effect is also obtained with the light source apparatus 110.

### (Seventh embodiment)

A seventh embodiment of the present invention is related to a projection-type display apparatus, and is related to a small projection-type display apparatus suitable for use with the light source apparatus explained in the first through sixth embodiments.

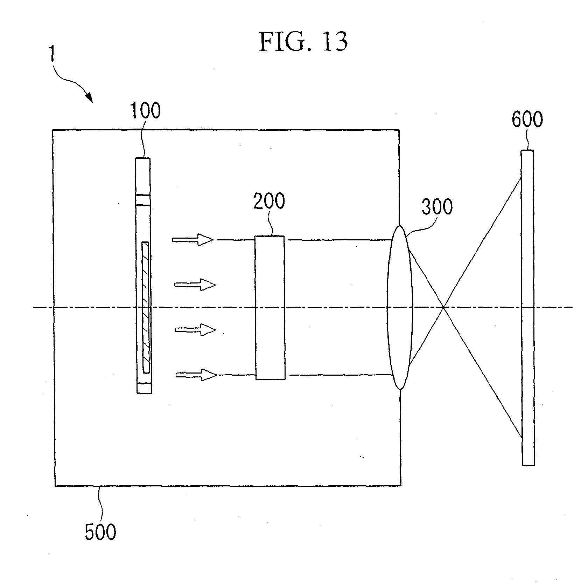

FIG. 13 is a schematic block diagram of an optical system of the projection-type display apparatus 1 of the present embodiment.

As shown in FIG. 13, the projection-type display apparatus 1 of the present embodiment includes a light source apparatus 100, a liquid crystal panel (optical modulator) 200, a projection lens 300, and a case 500. The liquid crystal panel is a so-called single-panel type projection-type display apparatus. The light source apparatus 100 employs the same light source apparatus as disclosed in the first embodiment. The light source apparatus 100 emits white light. The liquid crystal panel 200 permits optical modulation wherein light is transmitted or not transmitted in pixel units corresponding to changes in voltage of a control signal supplied to a drive circuit (not shown in drawings). Furthermore, the liquid crystal panel 200 is provided with a color filter, and color pixels are constituted by a plurality of pixels corresponding to RGB. Color display is then possible by controlling whether or not the R, G, and B light passes. These configurations are the same as liquid crystal panels provided in commonly available color filters. The projection lens 300 is configured to focus the image emitted from the liquid crystal panel 200 onto the screen 600. Only one projection lens is shown in this drawing, however a plurality of lenses may naturally be employed. The case 500 is configured to enclose the entire projection-type display apparatus, and to position each optical element appropriately.

In the aforementioned configuration of the present embodiment, high-brightness white light is emitted from the light source apparatus 100, and is optically modulated for each of R, G, and B with the liquid crystal panel 200. Light of each optically modulated color is synthesized into a bright color image on the screen 600, by the projection lens 300.

### (Eight embodiment)

An eighth embodiment of the present invention is related to a projection-type display apparatus, and is related to a small projection-type display apparatus suitable for use with the light source apparatus explained in the first through sixth embodiments. The eighth embodiment differs from the seventh embodiment in that it is provided with three light source apparatuses and three liquid crystal panels.

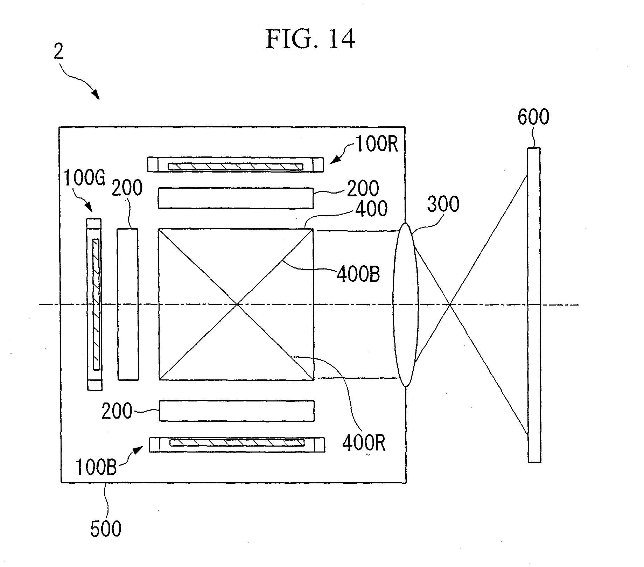

FIG. 14 is a schematic block diagram of an optical system of a projection-type display apparatus 2 of the present embodiment. The same reference symbols are employed for parts the same as in the seventh embodiment, and explanation of the configuration is omitted.

As shown in FIG. 14, the projection-type display apparatus 2 of the present embodiment includes light source apparatuses 100R, 100G, and 100B, three liquid crystal panels (optical modulators) 200, a dichroic prism 400, a projection lens 300, and a case 500. The three liquid crystal panels are the so-called single-panel type projection-type display apparatuses. Apart from the point that the respective LED chips of the light source apparatus 100R, 100G, and 100B emit red light, green light, and blue light respectively, the structure of these light source apparatuses 100R, 100G, and 100B is basically the same as the structure of the light source apparatus of the fifth embodiment. The light source apparatus 100R emits red light (R), the light source apparatus 100G emits green light (G), and the light source apparatus 100B emits blue light (B). If the color of the light emitted by the light source apparatus is to be constituted by LEDs which emit white light the same as for the seventh embodiment, then color filters to convert white light into R, G, and B light may be arrayed in the space between the light source apparatus 100 and the liquid crystal panel 200, or between the liquid crystal panel 200 and the dichroic prism 400. The dichroic prism 400 is provided with a multilayer film 400R able to reflect only R, and a multilayer film 400B able to reflect only B, and is configured to synthesize images which are optically modulated for each of R, G, and B, and emit these towards the projection lens 300.

In the aforementioned configuration of the present embodiment, high-brightness light of each color is emitted from the respective light source apparatus 100R, 100G, and 100B, and is optically modulated with the respective liquid crystal panels 200 for each light source apparatus. Light of each optically modulated color is synthesized into a bright color image on the screen 600, by means of the projection lens 300. A brighter color image can be obtained with this configuration than with the single-panel type projection-type display apparatus of the seventh embodiment.

The light source apparatus according to the embodiment of the present invention, and the projection-type display apparatus in which it is employed, have been explained above. However, it is possible to freely modify the embodiments, provided they are within the scope of the gist of the present invention. For example, in the third through sixth embodiments, the description was for where a ring-shaped container was employed for the sealed container. However, the advantages of the present invention can also be obtained by employing a box-shaped container similar to that in the first and second embodiments. Furthermore, in the embodiments, the description was for where LED chips were employed as light sources. However, a solid-state light emitting device such as a semiconductor laser or the like is also applicable to the present invention. Moreover, for example, in the embodiments, the description was for where a transparent liquid crystal panel was employed as the optical modulator. However a similar effect is obtained for a reflective liquid crystal panel (LCOS), a digital micro-mirror device (DMD), and the like, by using the light source apparatus of the present invention.

### (Ninth embodiment)

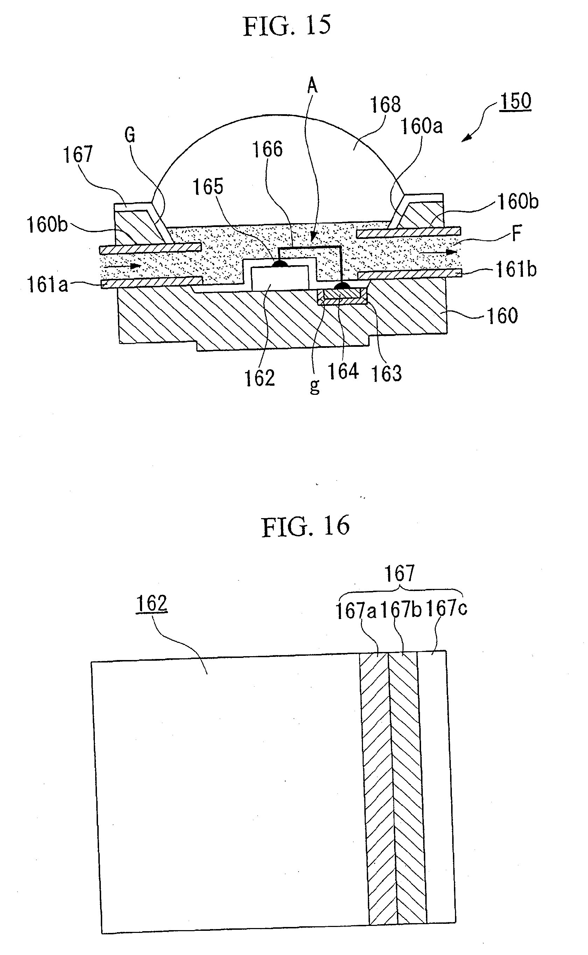

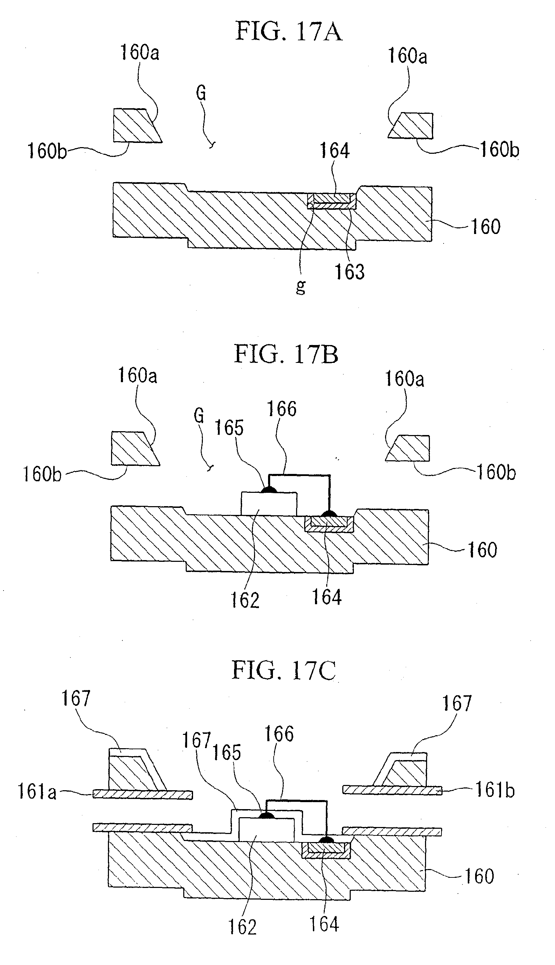

FIG. 15 is a sectional view showing a schematic configuration of a semiconductor light emitting device (LED) being an example of the light source apparatus according to a ninth embodiment of the present invention. FIG. 16 is an enlarged sectional view showing the configuration of the primary components of the solid-state light source (LED chip) consisting of this LED. FIG. 17A, and FIG. 17C are schematic process drawings for explaining a method of manufacture of this LED.

Ratios and the like of film thickness and dimensions of the constituent elements in all the following drawings, have been changed appropriately to facilitate viewing the drawings.

As shown in FIG. 15, a light source apparatus 150 of the present embodiment includes an LED chip 162 employed as a solid-state light source, mounted by a face-up package on a metal base 160.

The chip 162 is a semiconductor chip of a double-heterostructure wherein an AlGaInP active layer is sandwiched between n-type and p-type cladding layers, with an n-side electrode provided on the n-type cladding layer and facing downwards, and mounted on the base 160 with an Ag paste. The chip size is, for example, 1mm x 1mm.

The base 160 is formed from a highly reflective metallic material (for example, Al alloy), and this base 160 also functions as a reflector to reflect the light emitted by the chip 162. Furthermore, in the LED 150, the chip 162 is positioned in a depression G provided in the base 160 in order to improve the efficiency with which light is extracted from the chip 162. This depression G has a tapered slope 160a wherein the area of the opening increases with distance from the surface of the base, and light emitted from the chip 162 in the horizontal direction (the direction parallel to the bottom face of the base on which the chip is positioned) in relation to the mounting face of the chip, is reflected in the vertical direction in relation to the mounting face and thus extracted.

A groove g is provided inlaid in the bottom face of this depression G as a concave part, and a lead electrode 164 is inlaid in the interior of this inlaid groove g via an insulating film 163. This lead electrode 164 is, for example, connected to the p-side electrode 165 (the electrode on the side opposite the base 160) of the chip 162 via a metal bonding wire 166. A transparent lens cap 168 of plastic or the like is fitted to the base 160 so that it covers the top of the depression G. The interval between the chip 162 and the lens cap 168 is, for example, approximately 2 mm.

Moreover, a hole 160b communicating with the depression G is provided in the base 160. This hole 160b penetrates the interior of the base 160 in a direction parallel to the primary face of the base 160, and insulating flow path pipes 161a and 161b are inserted and fastened in the interior of the hole to pass the chip cooling fluid F. These pipes 161a and 161b are joined via a heat sink (not shown in drawings), and the cooling fluid F is circulated within the ring-shaped flow path. That is, the cooling fluid F is introduced into a space A enclosed by the depression G and a cap 168 via a pipe 161a. The chip 162 is then cooled, and the cooling fluid F is discharged from an other pipe 161 b, an cooled by a heat sink, and then introduced again into the space A via the pipe 161a.

The size of the pipes 161 a and 161 b is, for example, 2mm diameter. Furthermore, a liquid material such as silicon oil, water, or alcohol and the like, or a gas such as nitrogen and the like, may be employed as the fluid F. In the present embodiment, for example, nitrogen gas is employed at a temperature of 20°C and a flow rate of 2 cm³/s.

Moreover, in the present embodiment, in order to protect the device 1 from the fluid F, the surface of the member exposed to the fluid F within at least the space A is covered with a protective film 167 of a transparent inorganic insulating material. This protective film 167 is formed by vacuum deposition evaporation or the like, of an insulating material after the chip 162 is mounted on the base 160.

Preferably this protective film 167 is configured so that its refractive index is varied gradually from the chip side to the fluid side in order to raise the efficiency with which the emitted light is extracted. In practice, it is desirable that the protective film 167 includes a plurality of layers, and that the insulating layers having the protective film increase in refractive index from the chip side. The number of layers in this protective film can be determined freely in terms of insulation performance, heat dissipation, and productivity and the like. However, sufficient performance can be demonstrated with a laminated film of approximately three layers without loss of productivity. For example, in the present embodiment, the protective film 167 includes first, second, and third layers of insulating film in order from the chip side.

As materials for these insulating films, for example, TiO₂ (2.3~2.55), Ta₂O₅ (2.1), ZnO (2.1), and ZrO₂ (2.05) can be employed in the first insulating film 167a positioned closest to the chip 162 side, MgO (1.74) and Al₂O₃ (1.63) can be employed in the second insulating film 167b, and SiO₂ (1.54) and MgF₂ (1.38~1.40) can be employed in the third insulating film 167c positioned farthest from the chip. The figures in brackets represent the refractive indices of the materials of the insulating films.

Each insulating film may comprise a single material, or may has a number of the materials described above. Furthermore, since TiO₂ has a photocatalytic effect, it is desirable that an inorganic cooling fluid be employed when a TiO₂ protective film is employed, or that at least one layer of insulating film be laminated on the TiO₂ film to ensure that the TiO₂ film does not catalyze the fluid. Moreover, since MgO has low resistance to water, it is desirable that water not be employed as the cooling fluid when MgO is employed as a protective film. If water is employed as the cooling fluid, it is desirable that at least one layer of insulating film be laminated on the MgO film to ensure that the MgO film does not contact the fluid.

When the refractive index is gradually changed from the chip 162 side towards the fluid F side in this manner, the critical angle at which complete reflection occurs at each interface (interface of chip and insulating film, interface of adjacent insulating films, interface of insulating film and fluid) increases, and the proportion of light completely reflected is reduced, that is, the efficiency with which light is extracted increases.

In the present embodiment, for example, the first insulating film is of Ta₂O₅, the second insulating film is of Al₂O₃, and the third insulating film is of SiO₂. Furthermore, in the present embodiment, the thickness of the protective film is between 0.8 µm and 1.5 µm.

A variety of methods for formation of the films 167a, 167b, and 167c including vacuum deposition methods such as the spatter method, plasma CVD method, and the EB vacuum deposition method and the like, and liquid application methods such as the sol-gel method and SOG (Spin On Glass) method and the like, can be employed to form the insulating films 167a, 167b, and 167c. However it is desirable to use vacuum deposition methods to ensure a film of higher density.

The LED 150 can be manufactured with the following procedure.

Firstly, the base 160 with an integral reflector and provided with the hole 160a communicating with the depression G as shown in FIG. 17A is prepared. The chip 162 is then mounted on the depression G of the base 160 with an Ag paste, and wire-bonded (mounting process).

FIG. 17B shows the condition with the chip mounted.

The protective film 167 is formed (protective film formation step) with the chip 162 mounted in this manner. In the protective film formation step, the protective film 167 is formed to cover entirely the chip 162 (including electrodes) surface and the surface of the base 160 whereon the chip 162 is mounted. In practice, firstly, the insulating film 167a of Ta₂O₅ is formed on the surface of the chip 162 and the base 160 with the oblique vacuum deposition method. In this case, spattering is conducted while rotating the base 160 to ensure that the insulating film 167a is formed sufficiently in area in the shadow of the inner wall face 160a of the depression and the bonding wire 166. Next, the second insulating film 167b of Al₂O₃ is formed with the CVD method, and the third insulating film 167c of SiO₂ is formed with the vacuum deposition method. Thus, the protective film 167 on the chip surface is formed. FIG. 17C shows the condition following formation of the protective film. The thicknesses of the films, are for example, 250nm for the first insulating film, 500nm for the second insulating film, and 250nm for the third insulating film.

Once the protective film 167 is formed in this manner, the flow path pipes 161 a and 161b are attached, and the transparent lens cap 168 of plastic or the like is then fitted so that it covers the top of the depression G. The LED 150 is thus manufactured in this manner.

In the protective film formation step, it is not always necessary to form a protective film on the entire surface of the base. That is, since the purpose of the protective film 167 is protection from the fluid F, it is sufficient to form this protective film 167 so that it covers at least the entire face of the chip 162 and the base 160 exposed to the fluid F. With a film formation method wherein it is possible to selectively form the protective film 167, it is only necessary to form a protective film 167 on the surface of members positioned within the space A (see FIG. 15).

In this manner, since the entire external surface of the part of the chip 162 exposed to the cooling fluid F is covered with the protective film 167, shorting between the electrodes via the fluid F can be prevented in the present embodiment. In particular, in the present embodiment, since the protective film 167 is formed after the chip is mounted, the electrode 165 of the chip 162, and the surface of the base 160, are both covered by the protective film 167, and shorting in this manner can be more reliably prevented.

Moreover, in the present embodiment, since the chip 162 and the base 160 are completely separated from the cooling fluid F by the protective film 167, the chip 162 does not deteriorate due to a chemical reaction with the fluid F, and the base 160 does not deteriorate or corrode.

Since the temperature variation (temperature gradient) occurring at the interface with the fluid F is partially absorbed by the protective film 167, when the protective film 167 is positioned between the fluid F and the chip 162 in this manner, the temperature gradient occurring at the chip surface is less in comparison with the case wherein there is no protective film. For example, by cooling the fluid F, a temperature gradient of a few tens of degrees occurs within a film of a thickness of approximately 1µm forming the interface with the fluid F. When there is no protective film, this becomes the temperature gradient of the chip surface itself. However, since a plurality of layers having differing rates of thermal expansion are normally positioned on the chip surface within this thickness of approximately 1µm, a large distortion occurs between the layers due to this difference in rates of thermal expansion. This distortion not only changes the light-emitting characteristics of the chip, but also causes defects within the chip, thus providing a reason for a reduction in lifespan. On the other hand, in the configuration of the present embodiment, since the majority of the temperature gradient occurring within this thickness of approximately 1µm is absorbed by the protective film 167, the temperature gradient occurring within the chip itself is small. In practice, in the LEDs of the structure of the present embodiment, there are individual differences, but the half-life is increased by a factor of approximately 1.2 in comparison with the conventional case of no protective film.

Moreover, in the present embodiment, since the electrode 165 of the chip 167 is covered with the protective film 167, and the join between the wire 166 and the electrode 165 is fastened in place, the mechanical strength of the device is increased. In practice, when mounted by a face-up package, reliability of the wire connection is an important point, even with the conventional structure wherein direct cooling with the fluid is not employed, and in structures wherein the load of the fluid F is applied to the wire 166 join as in the present embodiment there is the risk of peeling of this joining part. The configuration of the present embodiment wherein this joining part can be reinforced with the protective film 167 is therefore valid from this point as well.

Furthermore, in the present embodiment, since the protective film 167 and the fluid F are of inorganic materials, these do not deteriorate due to the light emitted from the chip, thus furthermore improving the reliability of the device.

### (Tenth embodiment)

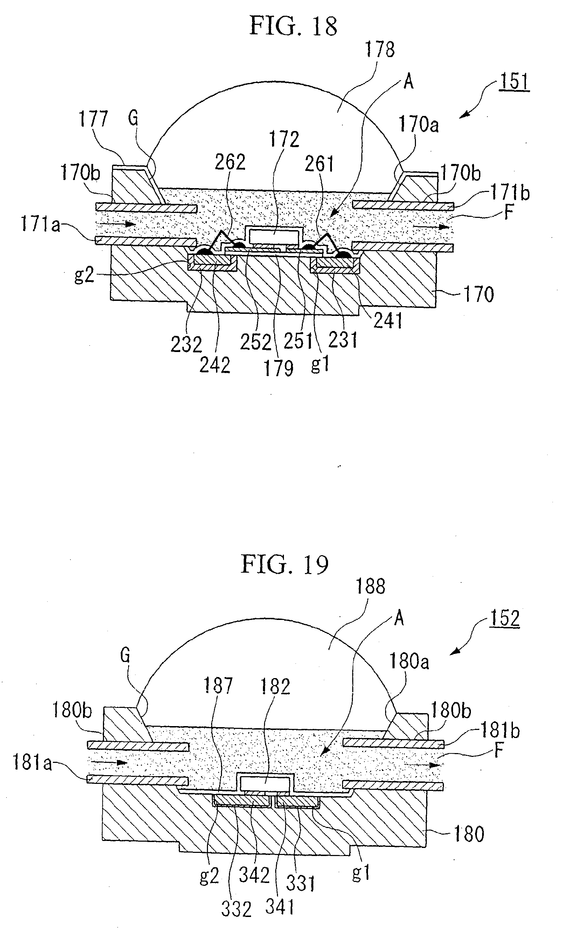

Next is a description of a light source apparatus according to a tenth embodiment of the present invention, with reference to FIG. 18.

In this embodiment, the same reference symbols are employed for members and sites the same as in the ninth embodiment, and explanation partly omitted.

An LED (light source apparatus) 151 of the present embodiment employs an LED chip 172 as a solid-state light source, mounted by a face-down package (flip-chip package) on a semiconductor material substrate 179, this substrate 179 being positioned on a metal base 170.

The chip 172, is formed from, for example, an InGaN-based mixed crystal, with both electrodes (anode and cathode) being connected to wiring 251 and 252 on the semiconductor substrate 179 with solder bumps or the like. Moreover, the wiring 251 and 252 is connected to the lead electrodes 241 and 242 each formed on the base 170 with, for example, the metal bonding wires 261 and 262. The chip size is, for example, 1 mm × 1 mm.

The base 170 is formed from a highly reflective metallic material (for example, Al alloy), and this base 170 also functions as a reflector to reflect the light emitted by the chip 172. Furthermore, in the LED 151, the chip 172 is positioned in the depression G provided in the base 170 in order to improve the efficiency with which light is extracted from the chip 172. This depression G has a tapered slope 170a wherein the area of the opening increases with distance from the surface of the base, and light emitted from the chip 172 in the horizontal direction (the direction parallel to the bottom face of the base on which the chip is positioned) in relation to the mounting face of the chip, is reflected in the vertical direction in relation to the mounting face and thus extracted.

Grooves g1 and g2 are provided inlaid in the bottom face of this depression G as concave parts, and lead electrodes 241 and 242 are inlaid in the interior of these inlaid grooves g1 and g2 via each insulating film 231 and 232. These lead electrodes 241 and 242 are, for example, connected to the electrodes 251 and 252 on the semiconductor substrate 179 with the bonding wires 261 and 262. A transparent lens cap 178 of plastic and the like is fitted to the base 170 so that it covers the top of the depression G. The interval between the chip 172 and the lens cap 178 is, for example, approximately 2mm.

Moreover, a hole 170b communicating with the depression G is provided in the base 170. This hole 170b penetrates the interior of the base 170 in a direction parallel to the primary face of the base 170, and insulating flow path pipes 171a and 171b are inserted and fastened in the interior of the hole to pass the chip cooling fluid F. These pipes 171a and 171b are joined via a heat sink (not shown in drawings), and the cooling fluid F is circulated within the ring-shaped flow path. The size of the pipes 171 a and 171b is, for example, 2 mm diameter. Furthermore, silicon oil at a temperature of 25°C and a flow rate of 0.2 cm³ /s is employed as the fluid F in the present embodiment.

Moreover, in the present embodiment, in order to protect the device 172 from the fluid F, the surface of the member exposed to the fluid F within at least the space A is covered with a protective film 177 of a transparent inorganic insulating material. This protective film 177 is a structure of three layers of, for example, ZrO₂, Al₂O₃, and SiO₂ in that order from the chip side in order to improve the efficiency with which light is extracted.

As explained above, the vacuum deposition method is suited to the formation of a more dense protective film. However, when a very small gap occurs between the base 170 and the semiconductor substrate 179, as is the case with face-down mounting, a sufficient film cannot be formed in this gap with the vacuum deposition method. Therefore, in the present embodiment, a liquid application method is suited to formation of the protective film 177. However, since the applied film presents problems in terms of density, then preferably only one part of the insulating film 177 is formed by a liquid application method, and the other parts are formed by the vacuum deposition method.

More specifically, after mounting the chip 172 on the base 170 and wire bonding, the first insulating film 271 of ZrO₂ is formed on the chip 172 and the base 170 surface by oblique vacuum deposition. In this case, spattering is conducted while rotating the base 170 to ensure that the insulating film is formed heterogeneously on the surface of the chip 172 and the base 170. Next, the second insulating film 272 of Al₂O₃ is formed with the CVD method. When the surface of the chip and base are covered with a dense insulating film in this manner, the third insulating film is then formed in the space between the chip 172 and the base 170 with the SOG method. In this formation step for the liquid application film, for example, SiO₂ dissolved to a concentration of approximately 5% in an organic solvent solution is applied to the chip 172 and the electrodes 251 and 252 and baked to a glass-like consistency at approximately 300°C for two hours to form the third insulating film of SiO₂. The thicknesses of the films, are for example, 250nm for the first insulating film, 500nm for the second insulating film, and 300nm for the third insulating film.

In this manner, in the present embodiment also, the temperature distribution gradient within the chip due to the protective film becomes milder, and the thermal stress due to the differing rates of thermal expansion is alleviated. Furthermore, since joins between bonding wires and lead electrodes, and joins between chip and semiconductor substrate, are fixed with the protective film, damage to the bonding wire, and peeling of the chip from the semiconductor substrate due to the flow of the fluid F, are prevented. Moreover, by separating the chip and the base from the fluid with the protective film, deterioration of the chip and the like can be prevented. Thus, the reliability of the chip is improved, and high-brightness can be achieved.

### (Eleventh embodiment)

Next is a description of a light source apparatus according to an eleventh embodiment of the present invention, with reference to FIG. 19.

In this embodiment, the same reference symbols are employed for members and sites the same as in the ninth and tenth embodiments, and explanation is partly omitted.

An LED (light source apparatus) 152 of the present embodiment employs an LED chip 182 as a solid-state light source, mounted by a face-down package on a metal base 180.

The chip 182, is formed from, for example, an InGaN-based mixed crystal, with both electrodes (anode and cathode) being connected to lead electrodes 341 and 342 of the base 180 with solder bumps or the like. The chip size is, for example, 1mm × 1mm.

The base 180 is formed from a highly reflective metallic material (for example, Al alloy), and this base 180 also functions as a reflector to reflect the light emitted by the chip 182. Furthermore, in the LED 152, the chip 182 is positioned in the depression G provided in the base 180 in order to improve the efficiency with which light is extracted from the chip 182. This depression G has a tapered slope 180a wherein the area of the opening increases with distance from the surface of the base, and light emitted from the chip 182 in the horizontal direction (the direction parallel to the bottom face of the base on which the chip is positioned) in relation to the mounting face of the chip, is reflected in the vertical direction in relation to the mounting face and thus extracted.

Grooves g1 and g2 are provided inlaid in the bottom face of this depression G as concave parts, and lead electrodes 341 and 342 are inlaid in the interior of these inlaid grooves g1 and g2 via each insulating film 331 and 332. Each lead electrode 341 and 342 is, for example, connected to the anode and cathode of the chip 182 with solder bumps and the like. A transparent lens cap 188 of plastic and the like is fitted to the base 180 so that it covers the top of the depression G. The interval between the chip 182 and the lens cap 188 is, for example, approximately 2mm.

Furthermore, a hole 180b communicating with the depression G is provided in the base 180. This hole 180b penetrates the interior of the base 180 in a direction parallel to the primary face of the base 180, and insulating flow path pipes 181a and 181b are inserted and fastened in the interior of the hole to pass the chip cooling fluid F. These pipes 181a and 181b are joined via a heat sink (not shown in drawings), and the cooling fluid F is circulated within the ring-shaped flow path. The size of the pipes 181a and 181b is, for example, 2 mm diameter. Moreover, pure water at a temperature of 25°C and a flow rate of 0.2 cm³/s is employed as the fluid F in the present embodiment.

Furthermore, in the present embodiment, in order to protect the device 152 from the fluid F, the surface of the member exposed to the fluid F within at least the space A is covered with a protective film 187 of a transparent inorganic insulating material. This protective film 187 has a structure of three layers of, for example, ZrO₂ , Al₂O₃, and SiO₂ in that order from the chip side in order to improve the efficiency with which light is extracted. This protective film 187 can be formed with the same procedure as in the tenth embodiment. That is, the first insulating film of ZrO₂ positioned on the chip, and the second insulating film of Al₂O₃, are formed with a vacuum deposition method, and the third insulating film of SiO₂ positioned farthest from the chip 182 is formed with a liquid application method. The formation steps for the protective film 187 are conducted after the chip is mounted.

In this manner, in the present embodiment also, the temperature distribution gradient within the chip due to the protective film becomes milder, and the thermal stress due to the differing rates of thermal expansion is alleviated. Moreover, by separating the chip and the base from the fluid with the protective film, deterioration of the chip and the like can be prevented. Thus, the reliability of the chip is improved, and high-brightness can be achieved.

### (Twelfth embodiment)

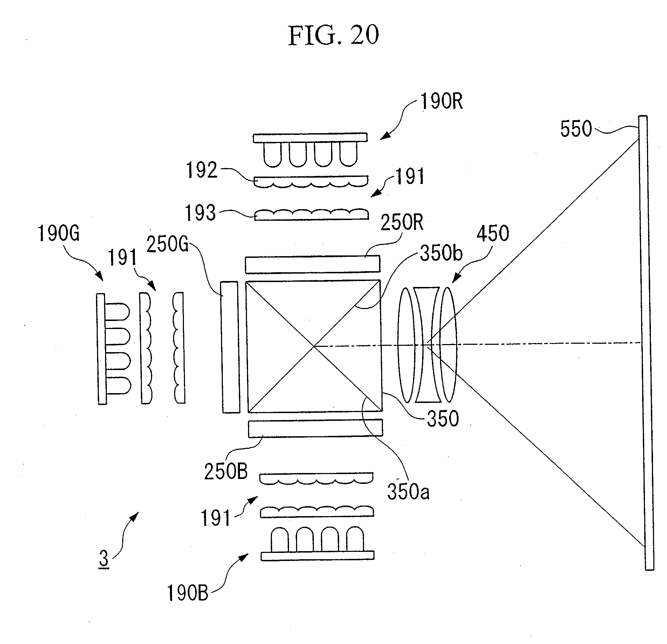

Next is a description of a projection-type display apparatus according to a twelfth embodiment of the present invention, with reference to FIG. 20.

The projection-type display apparatus of the present invention is a three panel projection-type color display apparatus provided with a transparent liquid crystal light valve for each of the differing colors R (red), G (green), and B (blue).

FIG. 20 is a schematic block diagram of the projection-type display apparatus. Reference symbols 190R, 190G, and 190B in the drawing indicate illumination apparatuses, 192 and 193 indicate fly-eye lenses, 250R, 250G, and 250B indicate liquid crystal light valves (optical modulators), 350 indicates a cross-dichroic prism (color synthesizing device), and 450 indicates a projection lens.

The light valves 250R, 250G, and 250B serving as optical modulators are positioned opposite each of the three light-incident faces of the dichroic cross prism 350 serving as a color synthesizing device, and the illumination apparatuses 190R, 190G, and 190B able to emit R (red), G (green), and B (blue) light are respectively positioned on the rear face sides (opposite sides to cross-dichroic prism 350) of each light valve. These illuminating apparatuses include a plurality of aforementioned light source apparatuses side-by-side mounted on the substrate.

The first fly-eye lens 192 and the second fly-eye lens 193 are installed between the illumination apparatuses 190R, 190G, and 190B and the corresponding light valves 250R, 250G, and 250B, in that sequence from the illumination apparatuses side as an illumination equalizing device 191 to ensure homogenous distribution of the illumination on the light valve. The first fly-eye lens 192 forms a plurality of secondary images of the light source, and the second fly-eye lens 193 functions as a superimposing lens to superimpose these images at the position of the illuminated area (the light valve), and thus the light emitted from the illuminating apparatus can illuminate the entire surface of the light valve with a uniform density irrespective of the light distribution.

The dichroic cross prism 350 has a structure wherein four right-angle prisms are abutted together, with a cross-shaped light reflective film formed from a laminated dielectric film (not shown in drawing) formed on the abutted faces 350a and 350b. In practice, light from the red image formed with the optical modulator 250R is reflected onto the abutted face 350a, a light-reflective film is provided for passage of the light from the green and blue images formed by the optical modulators 250G and 250B respectively, light from the blue image formed by the optical modulator 250B is reflected onto the abutted face 350b, and a light-reflective film is provided for passage of the light from the red and green images formed by the optical modulators 250R and 250G respectively. Light fed from each image by the light-reflective films is then projected onto the screen 550 with the projection lens 450.

Since in this manner, in the projection-type display apparatus of the present embodiment the aforementioned light source apparatus is provided as the illumination apparatus, a projection-type display apparatus of high brightness and reliability can be realized.

The present invention is not restricted to the aforementioned embodiments, and may be implemented with various modifications within a scope encompassing the gist of the present invention.

For example, for the aforementioned LEDs 150 to 152, the protective film has been described as a three-layer structure, however, this may be multilayer film of two-layers, or a four or more layers.

Furthermore, in the above embodiments, the light source apparatus has been described with the example of a semiconductor light emitting device, however, this light source apparatus may also be an organic EL device.

Moreover, the configuration of the light source apparatus shown in the above embodiment is not limited to this one example, and other configurations may also be employed. In any event, the light source apparatus comprises a solid-state light source, and a cooling mechanism which cools the solid-state light source by means of a cooling fluid, and the surface of the solid-state light source exposed to the fluid is completely covered by the protective film.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A light source apparatus comprising:
a mounting substrate;
at least one LED chip disposed on the mounting substrate;
a liquid; and
a sealed container for containing the mounting substrate, the at least one LED chip disposed thereon, and the liquid,
wherein the LED chip is in direct contact with the liquid, and
the sealed container has at least a part which is transparent to light emitted from the LED chip.

2. A light source apparatus according to claim 1, wherein a non-light emitting face side of the LED chip, opposite to a light emitting side, is exposed to the liquid for cooling.

3. A light source apparatus according to claim 1, wherein the sealed container comprises a cooling device for cooling the liquid contained therein.

4. A light source apparatus according to claim 1, wherein the sealed container comprises a circulating device for circulating the liquid contained therein.

5. A light source apparatus according to claim 1, wherein at least two LED chips are arranged in the thickness direction of the LED chips.

6. A light source apparatus according to claim 5, wherein
the at least two LED chips are formed with separator parts mutually therebetween, and
the separator parts are filled with the liquid.

7. A light source apparatus according to claim 5, wherein a reflective film is provided on the surface of the LED chip farthest from a light emitting section of the sealed container.

8. A light source apparatus according to claim 5, wherein a reflective plate is provided parallel to the at least two of LED chips, on the side of the LED chip farthest from the light emitting face of the sealed container.

9. A projection-type display apparatus comprising:
a light source apparatus according to claim 1;
an optical modulator for modulating light from the light source apparatus; and
a projection lens for projecting modulated light from the optical modulator.

10. A light source apparatus comprising:
a base;
a solid-state light source mounted on the base;
a cooling fluid;
a device for cooling the solid-state light source by the cooling fluid in direct; and
a protective film including a transparent insulating material on an external surface having electrodes of the solid-state light source, for covering completely at least a surface of the solid-state light source exposed to the cooling fluid.

11. A light source apparatus according to claim 10, wherein the protective film is provided so as to cover the surface of the base exposed to the fluid.

12. A light source apparatus according to claim 10, wherein the protective film comprises an inorganic material.

13. A light source apparatus according to claim 10, wherein the protective film comprises a laminated film of a plurality of insulating film having mutually differing refractive indices, and
the plurality of insulating film are laminated together in order of increasing refractive index in relation to the solid-state light source.

14. A light source apparatus according to claim 13, wherein the protective film comprising, in order, from the solid-state light source:
a first layer of insulating film including at least one of TiO₂, Ta₂O₅, ZnO, and ZrO₂;
a second layer of insulating film including at least one ofMgO and Al₂O₃; and
a third layer of insulating film including at least one of SiO₂ and MgF₂.

15. A light source apparatus according to claim 10, wherein the cooling fluid comprises an inorganic material.

16. A light source apparatus according to claim 10, wherein the cooling fluid is a liquid material.

17. A light source apparatus according to claim 10, wherein a thickness of the protective film is greater than 0.8 µm and less than 1.5 µm.

18. A method of manufacturing a light source apparatus in which a solid-state light source is cooled directly by a fluid, the method comprising:
a mounting step for mounting the solid-state light source on a base; and
a protective film formation step for forming a transparent protective film including an insulating material on an external surface having electrodes of the mounted solid-state light source, so that at least a surface of the solid-state light source exposed to the fluid is completely covered.

19. A method of manufacturing a light source apparatus according to claim 18, wherein in the protective film formation step, at least a protective film disposed on an interface with the solid-state light source is formed by a vacuum deposition method.

20. A method of manufacturing a light source apparatus according to claim 18, wherein in the protective film formation step, the protective film is formed by a rotating oblique vacuum deposition method.

21. A method of manufacturing a light source apparatus according to claim 18, wherein the mounting step is a step for mounting the solid-state light source on a base by a face-down package, and
the protective film formation step forms at least part of the protective film by a liquid application method.

22. A method of manufacturing a light source apparatus according to claim 21, wherein the protective film formation step is a step for forming the protective film as a plurality of laminated insulating films, and
in the protective film formation step, the insulating film disposed closest to the solid-state light source side is formed by a vacuum deposition method, and the insulating film disposed farthest from the solid-state light source side is formed by a liquid application method.

23. A method of manufacturing a light source apparatus according to claim 21, wherein a thickness of the protective film of a part formed by the liquid application method is less than 0.3 µm.

24. A projection-type display apparatus comprising:
a light source apparatus according to claim 10;
an optical modulator for modulating light from the light source apparatus; and
a projection lens for projecting modulated light from the optical modulator.
